Europäisches Patentamt

European Patent Office

Office européen des brevets

(11) Publication number: 0 377 224
A2

## (12) EUROPEAN PATENT APPLICATION

(21) Application number: 89124148.1

(22) Date of filing: 29.12.89

(51) Int. Cl.5: H01J 37/317, H01J 37/20, H01L 21/00

(30) Priority: 29.12.88 CS 9022/88

(43) Date of publication of application:
11.07.90 Bulletin 90/28

(84) Designated Contracting States:
CH DE FR GB LI NL

(71) Applicant: Tesla, Koncernovy Podnik
No. 186 Podebradska
Praha 9(CS)

(72) Inventor: Dynda, Vladimir, Dipl.-Ing. CSc
Kropáckova 563
Praha 4(CS)
Inventor: Novotny, Karel
Zálesi 1129
Praha 4(CS)
Inventor: Ambroz, Zdenek, Dipl.-Ing.
Kolského 1441
Praha 4(CS)
Inventor: Kubicek, Jiri, Dipl.-Ing.
Buková 397/2a
Praha 3(CS)

(74) Representative: Patentanwälte Beetz sen. -
Beetz jun. Timpe - Siegfried -
Schmitt-Fumian- Mayr
Steinsdorfstrasse 10
D-8000 München 22(DE)

(54) Method and vacuum chamber for ion implantation.

(57) The invention relates to a method and a vacuum chamber (1) for ion implantation where the removal of the heat from the surfaces of the substrates (7) generated during ion implantation is effected by means of heat pipes (2) carrying the supports (5) for the substrates (7) at their hot ends, their cold ends being provided with temperature control means (3, 8, 9).

## Method and vacuum chamber for ion implantation

The invention relates to a method and a vacuum chamber for ion implantation; for instance for implantation of boron, phosphorus or arsenic ions into semiconductor substrates where means are provided for removal of the heat generated during ion implantation from the substrates.

In many cases of ion implantation the surface of the substrates to be implanted are to be maintained at a low temperature. In the case of the so-called group implantation in vacuum, the heat is removed from the substrates by heat transfer to an elastomeric backing plate and to the body of a support and therefrom to a supporting implantation disk or, according to technologically more advantageous solutions, directly into a cooling medium, passing through the support of the substrate. Water is usually applied as cooling medium. The maximum possible specific implantation efficiency ($W/cm^2$) depends on the maximum allowed temperature of the substrate, the temperature of the cooling medium and on the heat conductivity of the whole system between the substrate and the cooling medium. The main drawback of these solutions is the limited achievable heat gradient between the surface of the substrate to be implanted and the cooling medium, the temperature of which is always above 0 °C, particularly when water is used as cooling medium. This drawback is particularly apparent in the case of heat transfer to an implantation disk.

Similar problems occur also in the case of single plate implantation accomplished either in the same way as mentioned above or with group implantation or in the case of heat removal using a low pressure gas flowing behind the rear face of the implanted substrates. A common drawback of the above mentioned prior art solutions resides in the fact that only a limited heat gradient can be achieved between the surface of the implanted substrates and the support at temperatures above 0 °C due to the heat transfer from the substrate through the elastomeric backing plate to the support even if the whole system is provided in the vacuum.

It is an object of the present invention to provide a method and a vacuum chamber for ion implantation enabling to apply high dosis of ion implantation power to different substrates by means of improved heat transfer from the implanted substrates, with achieving a uniform distribution of implantation and good reproducibility.

The above object is achieved according to the claims, the dependent claims relating to preferred embodiments.

The method according to the present invention for ion implantation in a vacuum chamber comprising one or more supports for the substrates to be implanted provided with means for temperature control and means for connecting to an ion beam source is based on fixing the substrates to be implanted on the supports and irradiating the substrates with an ion beam of predetermined output power for a predetermined duration with temperature control of the supports; it is characterized in that the temperature of the supports is controlled by means of one or more closed heat pipes, the hot ends thereof being provided in the vacuum chamber and carrying the supports of the substrates, and the cold ends thereof being temperature controlled, preferably being cooled, by means of a liquid heat carrier medium.

The vacuum chamber according to the present invention which is particularly suited for carrying out the above defined method comprises means for connecting to an ion beam source and one or more supports for the substrate to be implanted provided with means for temperature control and with means for fixing the substrates thereon; it is characterized in that the means for temperature control are one or more closed heat pipes 2, particularly having thermal and electrical conductivity, filled with a suitable, evaporatable liquid, the hot ends thereof being provided in the vacuum chamber and carrying the supports for the substrates, and the cold ends thereof being provided with means for temperature control, preferably for cooling.

The cold ends of the heat pipes 2 are preferably situated outside the vacuum chamber within a thermostat body.

In accordance with a preferred embodiment of the present invention, the vacuum chamber is of substantially rotationally symmetrical shape and comprises a cover provided with an eccentrically arranged opening for passage of the ion beam, a plurality of heat pipes provided at their hot ends with substantially planar supports for the substrates to be implanted, a hollow thermostat body of substantially cylindrical shape rotatably provided in the central part of the bottom wall of the vacuum chamber by means of a vacuum-tight rotary passage and carrying the heat pipes, preferably in a radial arrangement, the cold ends thereof being situated within the thermostat body comprising an inlet and an outlet for a heat carrier medium, preferably a cooling medium, for temperature control of the cold ends of the heat pipes, and means for rotating the thermostat body with respect to the vacuum chamber, thus enabling the substrates to pass consecutively the opening in the cover of the vacuum chamber.

According to the above mentioned embodiment, the cold ends of the heat pipes 2 are provided in openings of the thermostat body in a radial arrangement and are preferably evenly distributed along a circle around the rotation axis.

The heat pipes are filled with a suitable liquid which may pass in the course of operation from the liquid state to the gaseous state and vice versa, thus transporting heat from the hot to the cold ends, as known as such to those skilled in the art.

Many evaporatable liquids can be used as heat transfer liquids in the heat pipes, for example distilled water, alcohols such as methanol and other known media.

In accordance with another preferred embodiment the supports carrying substrates are arranged such that, in cross-section, their surfaces directed towards the ion beam are arranged at an angle different from 90° with respect to the axis of the ion beam, preferably at an angle < 90°.

In accordance with another embodiment, the axes of the cold ends of the heat pipes are arranged parallel to the longitudinal, rotation axis of the thermostat body, and those parts of the heat pipes protruding into the vacuum chamber are bent radially outwardly to form, in cross-section, an obtuse angle $\beta > 90°$ between the hot and cold ends thereof, i.e. to form an acute angle $\alpha < 90°$ between the hot ends and the longitudinal, rotation axis of the thermostat body.

Because of the use of heat pipes for temperature control of the supports for the substrates to be implanted, there is no restriction concerning the operation temperatures of the hot and cold ends of the heat pipes, which may be properly selected with consideration of the respective ion implantation to be carried out. Accordingly, the heat pipes can be operated well below 0 °C. In this case the heat transfer medium used for the temperature control of the thermostat body may be a usual cryo medium such as a freon or freon mixtures.

Another advantageous embodiment of the vacuum chamber is characterized in that the vacuum chamber including the supports is arranged such as to allow a relative movement with respect to the ion beam in a plane perpendicular to the longitudinal axis of the thermostat body.

The means for fixing the substrates to be implanted on the supports are elastomer layers, which preferably comprise additives improving the heat conductivity thereof.

In the following, the invention will be described with reference to a preferred embodiment shown in the drawings in sectional elevation.

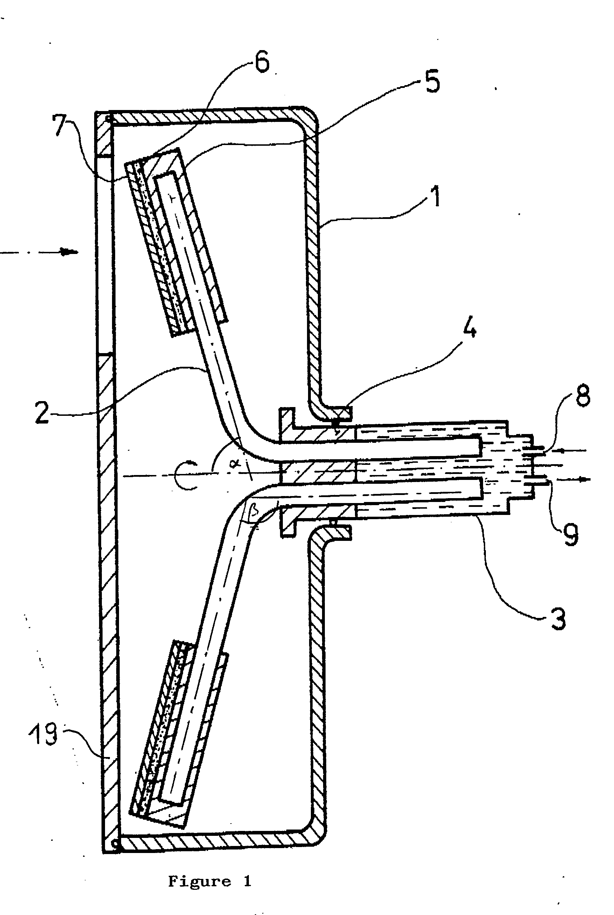

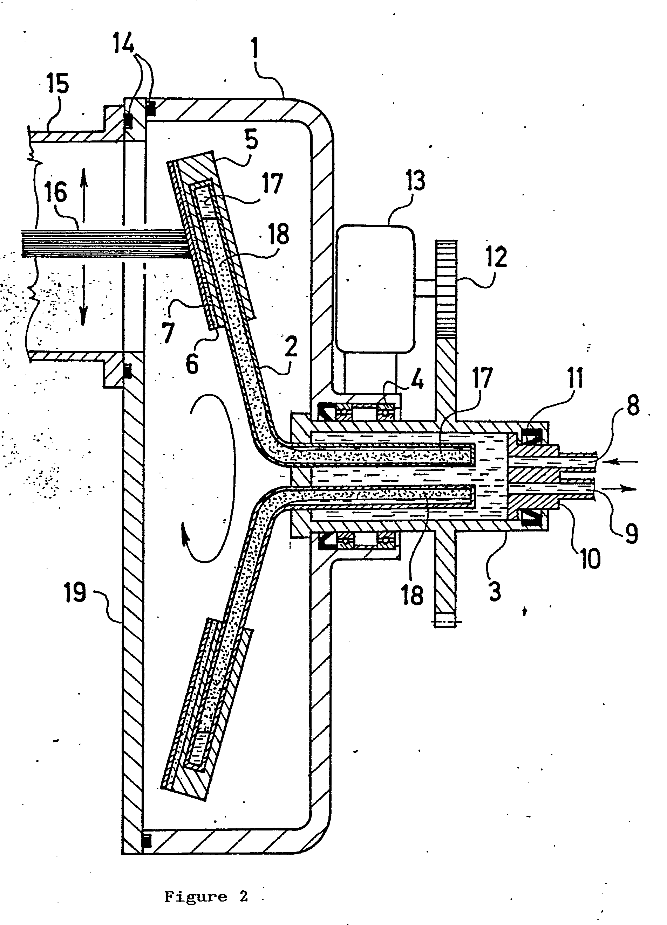

Figure 1 (cf. also the respective parts shown in Figure 2) shows a vacuum chamber 1 of substantially rotationally symmetrical shape comprising a cover 19 having an opening for passing the ion beam as indicated by means of the arrow. A hollow thermostat body 3 of substantially cylindrical shape is rotatably provided in the central part of the bottom wall of the vacuum chamber 1 by means of a vacuum-tight rotary passage which may be a ferromagnetic vacuum packing 4. The face wall of the thermostat body 3 facing the interior of the vacuum chamber 1 is provided with a number of openings arranged radially along a circle. These openings, heat pipes 2 are provided with their cold ends, the longitudinal axis of these cold ends of the heat pipes 2 being parallel to the longitudinal, rotation axis of the thermostat body 3 and being bent radially outwardly such that their hot ends protruding into the interior of the vacuum chamber 1 form an acute angle $\alpha < 90°$ with the central, rotation axis of the thermostat body 3. Accordingly, the bending angle $\beta$ of the heat pipes 2 between the hot and colds ends is an obtuse angle.

The hot ends of the heat pipes 2 are provided with supports 5 for the substrates 7 to be implanted which are attached to the supports by means of elastomeric layers 6.

The thermostat body 3 is provided with an inlet 8 and an outlet 9 for the heat carrier medium for the temperature control of the cold ends of the heat pipes 2. The inlet 8 and the outlet 9 of the thermostat body is rotatably pivoted for allowing rotation of the thermostat body 3.

Figure 2 shows an embodiment of the vacuum chamber according to the present invention with a more detailed representation of the heat pipe and thermostat body arrangement including the connection of the heat carrier medium lines and the drive system.

In principle, the heat pipes and the thermostat body have the same structure and arrangement as described with reference to Figure 1. In accordance therewith, the same reference numerals as in Figure 1 are used in Figure 2 for the same parts of the vacuum chamber. The thermostat body 3 shown in Figure 2 comprises a pivot 10 rotatably provided at the outer end of the thermostat body and comprising the inlet 8 and the outlet 9 for the heat carrier medium. The pivot 10 has a pressure-tight sealing which is for example a packing 11. An electric motor 13 serves for rotating the thermostat body 3 by way of a pinion and a transmission gear 12. Accordingly, the thermostat body is provided with a corresponding gear. The vacuum-tight packing between the thermostat body and the bottom wall of the vacuum chamber 1 is again a ferro-magnetic vacuum packing 4.

The heat pipes 2 are closed at both ends and are partly filled with a liquid 17 which evaporates at the hot ends thereof to form vapor 18 which is condensed at the cold ends thereof within the thermostat body 3.

The hot ends of the bent heat pipes 2 carry the supports 5 where, by means of the elastomeric layers 6, the substrates 7 are mounted. The opening in the cover 19 of the vacuum chamber 1 provided for the passage of the ion beam 16 is connected to a vacuum tube 15. The vacuum-tight sealing between the vacuum tube 15 and the cover 19, and the vacuum-tight sealing between the cover 19 and the body part of the vacuum chamber 1 is provided by means of the suitable sealing, for example a packing or a rubber ring 14.

Any suitable cooling medium can be used for the thermostat body 3 which is commonly used in closed systems such as refrigerator systems (compressor-liquefier-regulated vaporizer).

The whole arrangement of the vacuum chamber 1 is electrically connected to the ion beam source in the usual way.

In the drawings, only two heat pipes 2 are shown; nevertheless, generally a larger number of heat pipes including supports is used.

For operating the device, substrates 7, for instance silicon plates or wafers or similiar planar objects which are to be implanted are fixed to the supports 5 after opening the vacuum chamber 1. After fixation of the substrates, the vacuum chamber 1 is closed and evacuated in order to obtain a high vacuum better than $10^{-2}$ Pa. The thermostat body 3 with the attached unit comprising the substrates 7 to be implanted is then started to rotate, generally at a speed of up to 1000 $min^{-1}$. An ion beam 16 is directed onto the substrates 7 just opposite of the opening in the cover 19 at an angle different from 90°. In order to achieve a high uniformity of implantation, the vacuum chamber with the thermostat body 3 and the unit comprising the substrates 7 is shifted with respect to the stable part comprising the source of the ion beam 16. After the substrates 7 have received the required dosis of ions, the source of the ion beam 16 is switched off, and the rotation of the thermostat body 3 comprising the heat pipes 2 with the supports 5 and the substrates 7 is stopped. The vacuum in the vacuum chamber 1 is eliminated by introducing air or another suitable gas; then, the vacuum chamber 1 is opened. After replacement of the substrates 7, the same working circle can be repeated.

Due to the impact of ions onto the surface of the substrates 7 heat is generated, the amount of which depends on the energy of the implanted particles and their quantity. This heat can be as high as in the kW range. Accordingly, it is necessary to remove this heat in order that the temperature of the implanted substrates 7 generally does not rise above 100 to 200 °C to prevent any damage of their structure.

The heat pipes as provided and used according to the present invention serve for removing the heat from the substrates and for transporting it to the thermostat body 3. In the course of rotation of the unit comprising the substrates 7, the liquid 17 within the heat pipes 2 is urged due to the centrifugal forces to the hot ends thereof provided with the supports 5 for the substrates 7. Due to the heat generated by the impact of the implanted ions the liquid 17 within the heat pipes 2 is evaporated. The thus created vapors 18 reach, due to the generated pressure, the opposite, cold end of the heat pipes 2 situated within the internal space of the thermostat body 3 filled with the cooling medium where the vapors 18 are condensed. The liquefied condensates flow along the internal surfaces of the heat pipes 2 back to the opposite, hot end thereof, supported by the centrifugal forces which can amount up to 100 G (relative centrifugal acceleration ratio).

The vacuum chamber according to this invention is suitable for implantation of large dosis of implantation materials, such as $5 \cdot 10^{16}$ $ions/cm^2$ of boron, phosphorus or arsenic to semiconductor substrates, for instance silicon plates or wafers of different diameters (for instance 100 or 150 mm) with maintaining a uniformity of ion implantation and a reproducibility of the whole operation within a deviation of smaller than 1 %.

In order to achieve a uniform distribution of implanted ions, the ion beam having a power of 15 to 200 keV and a current up to 10 mA, the whole unit comprising the rotating substrates 7 performs, in addition to its rotational motion, also a periodical straight line motion within a plane perpendicular to the rotation axis of the thermostat body 3.

According to another preferred embodiment of the present invention, the heat pipes 2 carrying the supports 5 for the substrates 7 can be radially arranged in a plane vertical to the axis of rotation of the thermostat body 3. In that case, only the supports 5 for the substrates 7 are arranged in such a manner that the impact of ions on the substrates 7 occurs at an angle different from 90°, i.e. the surface of the substrates 7 forming, in cross-section, an angle different from 90° with the axis of the ion beam 16.

In accordance with another preferred embodiment, the heat pipes 2 can be provided in the thermostat body along or parallel to its longitudinal axis, the substrates 7 being arranged vertically.

## Claims

1. A method for ion implantation in a vacuum chamber (1) comprising one or more supports (5) for the substrates (7) to be implanted provided with means for temperature control and means for connecting to an ion beam source, by fixing the substrates (7) to be implanted on the supports (5) and irradiating the substrates (7) with an ion beam (16) of predetermined output power for a predetermined duration with temperature control of the supports (5),

**characterized** in that
the temperature of the supports (5) is controlled by means of one or more heat pipes (2) the hot ends thereof being provided in the vacuum chamber (1) and carrying the supports (5) for the substrates (7), and the cold ends thereof which are preferably situated outside the vacuum chamber (1) being temperature controlled, preferably being cooled.

2. A vacuum chamber (1) for ion implantation comprising
means (14, 15) for connecting to an ion beam source, and one or more supports (5) for the substrats (7) to be implanted provided with means for temperature control and with means (6) for fixing the substrates (7), particularly for carrying out the method according to claim 1,
characterized in that
the means for temperature control are one or more closed heat pipes (2) filled with a suitable, evaporatable liquid (17), the hot ends thereof being provided in the vacuum chamber (1) and carrying the supports (5) for the substrate (7), and the cold ends thereof being provided with means (3, 4, 8, 9) for temperature control, preferably for cooling.

3. The vacuum chamber according to claim 2, characterized in that the cold ends of the heat pipes (2) are situated outside the vacuum chamber (1).

4. The vacuum chamber according to claims 2 and 3, characterized in that it is of substantially rotationally symmetrical shape and comprises a cover (19) provided with an eccentrically arranged opening for passage of the ion beam (16), a plurality of heat pipes (2) provided at their hot ends with substantially planar supports (5) for the substrate (7) to be implanted, a hollow thermostat body (3) of substantially cylindrical shape rotatably provided in the central part of the bottom wall of the vacuum chamber (1) by means of a vacuum-tight rotary passage and carrying the heat pipes (2) in a radial arrangement, the cold ends thereof being situated within the thermostat body (3) comprising an inlet (8) and and outlet (9) for a heat carrier medium, preferably a cooling medium, for temperature control of the cold ends of the heat pipe, and means (12, 13) for rotating the thermostat body (3).

5. The vacuum chamber according to claims 2 to 4, characterized in that the supports (5) for carrying the substrates (7) are arranged such that, in cross-section, their surfaces directed towards the ion beam (16) are arranged at an angle different from 90° with respect to the axis of the ion beam (16), preferably at an angle < 90°).

6. The vacuum chamber according to claims 2 to 5, characterized in that the axes of the cold ends of the heat pipes (2) are arranged parallel to the longitudinal, rotation axis of the thermostat body (3), and those parts of the heat pipes (2) protruding into the vacuum chamber (1) are bent radially outwardly to form, in cross-section, an obtuse angle $\beta >90°$ between the hot and cold ends thereof.

7. The vacuum chamber according to claims 2 to 6, characterized in that the vacuum chamber including the supports (5) is arranged such as to allow a relative movement with respect to the ion beam (16) in a plane perpendicular to the longitudinal, rotation axis of the thermostat body (3).

8. The vacuum chamber according to claims 2 to 7, characterized in that the means for fixing the substrates to be implanted are elastomer layers (6).

9. The vacuum chamber according to claims 2 to 8, characterized in that the elastomer layers (6) comprise additives improving the heat conductivity.

10. The vacuum chamber according to claims 2 to 9, characterized in that the heat pipes (2) are made of a material having thermal conductivity.

Figure 1

Figure 2